Europäisches Patentamt

European Patent Office

Office européen des brevets

(19)

(11) **EP 1 501 121 A1**

(12) **EUROPEAN PATENT APPLICATION**
published in accordance with Art. 158(3) EPC

(43) Date of publication:
26.01.2005 Bulletin 2005/04

(51) Int Cl.⁷: **H01L 21/31**

(21) Application number: **03717578.3**

(22) Date of filing: **14.04.2003**

(86) International application number:
**PCT/JP2003/004718**

(87) International publication number:
**WO 2003/090271 (30.10.2003 Gazette 2003/44)**

(84) Designated Contracting States:
**DE FR GB IT NL**

(30) Priority: **19.04.2002 JP 2002117672**

(71) Applicant: **TOKYO ELECTRON LIMITED**
**Minato-ku, Tokyo 107-8481 (JP)**

(72) Inventors:
• **Matsuura, Hiroyuki,**
**TOKYO ELECTRON LIMITED**
**Tokyo 107-8481 (JP)**

• **Takahashi, Yutaka, TOKYO ELECTRON LIMITED**
**Tokyo 107-8481 (JP)**

(74) Representative: **Schrell, Andreas, Dr. et al**
**Gleiss Grosse Schrell & Partner**
**Patentanwälte Rechtsanwälte**
**Leitzstrasse 45**
**70469 Stuttgart (DE)**

(54) **FILM FORMATION METHOD**

(57) A film formation method includes a preparation stage (S10) and a process stage (S20). In the preparation stage (S10), a process time correction equation prepared to correct process time in accordance with atmospheric pressure is derived, based on a first relational equation that expresses a relationship between film thickness and process time, and a second relational equation that expresses a relationship between atmospheric pressure and film thickness (S11 to S14). In the process stage (S20), process time is corrected, based on the process time correction equation thus derived and a measurement result of current atmospheric pressure, and then film formation is performed, based on process time thus corrected (S21 to S23).

FIG. 2

## Description

Technical Field

The present invention relates to a film formation method, a method of deriving a correction equation of film formation process time, a film formation apparatus, and a derivation method program. Particularly, the present invention relates to improvement of a film formation method for a semiconductor process. The term "semiconductor process" used herein includes various kinds of processes which are performed to manufacture a semiconductor device or a structure having wiring layers, electrodes, and the like to be connected to a semiconductor device, on a target substrate, such as a semiconductor wafer or an LCD substrate, by forming semiconductor layers, insulating layers, and conductive layers in predetermined patterns on the target substrate.

Background Art

In semiconductor manufacturing processes, a vertical heat-processing apparatus for performing a batch process is used as a film formation apparatus. In this apparatus, a holder, such as a wafer boat, is used to hold a number of wafers stacked at intervals. The holder is loaded into a vertical heat-processing furnace, which is then supplied with a reactive gas, such as oxygen, to perform film formation. In accordance with the type of the reactive gas supplied into the heat-processing apparatus, an oxide film or another film is formed on the wafers.

In general, the gas pressure within a heat-processing furnace is measured, using atmospheric pressure used as a reference. For example, a relative-pressure sensor is employed to measure the gas pressure based on a differential pressure from atmospheric pressure. Accordingly, if both of atmospheric pressure and the gas pressure (absolute pressure) within the heat-processing furnace vary, the fluctuations in the gas pressure within the heat-processing furnace cannot be detected from measured values, as the case may be. As a result, the thickness of a formed film may vary, due to atmospheric pressure fluctuations.

Disclosure of Invention

An object of the present invention is to reduce film thickness variation due to atmospheric pressure fluctuations, in a film formation process.

According to a first aspect of the present invention, there is provided a film formation method comprising a preparation stage and a process stage. The preparation stage comprises a first film formation step of forming films, while using different process times; a first measurement step of measuring film thickness of the films formed in the first film formation step; a first derivation step of deriving, based on measured data obtained in the first measurement step, a first relational equation that expresses a relationship between film thickness and process time; a second film formation step of forming films, while controlling process gas pressure with reference to different values of atmospheric pressure; a second measurement step of measuring film thickness of the films formed in the second film formation step; a second derivation step of deriving, based on measured data obtained in the second measurement step, a second relational equation that expresses a relationship between atmospheric pressure and film thickness; and a third derivation step of deriving, based on the first and second relational equations derived in the first and second derivation steps, a process time correction equation prepared to correct process time in accordance with atmospheric pressure fluctuations. The process stage comprises a correction step of correcting process time, based on a measurement result of current atmospheric pressure and the process time correction equation derived in the third derivation step; and a film formation step of forming a film, while controlling process gas pressure with reference to atmospheric pressure, based on process time corrected in the correction step.

According to the method of the first aspect, in the preparation stage, a process time correction equation prepared to correct process time in accordance with atmospheric pressure is derived, based on a first relational equation that expresses a relationship between film thickness and process time, and a second relational equation that expresses a relationship between atmospheric pressure and film thickness. In the process stage, process time is corrected, based on the process time correction equation thus derived and a measurement result of current atmospheric pressure, and then film formation is performed, based on process time thus corrected. Since the process time correction equation is used to correct process time in accordance with atmospheric pressure, it is possible to reduce film thickness variation due to atmospheric pressure fluctuations.

An example of "to control process gas pressure with reference to atmospheric pressure" is to control a gas pressure in a process chamber by a gas pressure measuring device using atmospheric pressure as a reference (such as a relative-pressure sensor that measures the gas pressure based on a differential pressure from atmospheric pressure). This control may be performed by a manual operation or an automatic operation. For example, one or both of a gas flow rate into a process chamber and volume displacement from the process chamber are adjusted to control the gas pressure within the process chamber.

The order of the set of the first film formation step, first measurement step, and first measurement step, and the set of the second film formation step, second measurement step, and second measurement step may be reversed without problem. For example, the second film formation step may be performed before the first film formation step, the second measurement step may be performed before the first measurement step, or the second derivation step may be performed before the first derivation step. To summarize, it suffices that both of the first and second relational equations are derived before the third derivation step.

According to a second aspect of the present invention, there is provided a film formation process time correction equation derivation method of deriving a process time correction equation prepared to correct process time in accordance with atmospheric pressure fluctuations, in performing film formation while controlling process gas pressure with reference to atmospheric pressure, the method comprising: a first derivation step of deriving, based on first measured data, a first relational equation that expresses a relationship between film thickness and process time; a second derivation step of deriving, based on second measured data, a second relational equation that expresses a relationship between atmospheric pressure and film thickness; and a third derivation step of deriving, based on the first and second relational equations derived in the first and second derivation steps, a process time correction equation prepared to correct process time in accordance with atmospheric pressure fluctuations.

According to a third aspect of the present invention, there is provided a film formation apparatus comprising: a process chamber configured to place a substrate therein; a gas supply system configured to supply a reactive gas into the process chamber; an atmospheric pressure measuring device configured to measure atmospheric pressure; a storage section configured to store a process time correction equation prepared to correct process time in accordance with atmospheric pressure fluctuations; a process time correction section configured to correct process time, based on the process time correction equation stored in the storage section; and a control section configured to control the gas supply system, based on a measurement result obtained by the atmospheric pressure measuring device and process time corrected by the process time correction section.

According to the apparatus of the third aspect, process time is corrected by the process time correction section, based on a measurement result obtained by a gas pressure measuring device, and then a film formation process is performed in accordance with the corrected process time. As a consequence, it is possible to reduce film thickness variation due to atmospheric pressure fluctuations.

Brief Description of Drawings

FIG. 1 is a partly sectional view showing a vertical heat-processing apparatus, which is a film formation apparatus for a semiconductor process according to an embodiment of the present invention;
FIG. 2 is a flow chart showing an example of a sequence of preventing film thickness variation due to atmospheric pressure;
FIG. 3 is a graph showing an example of a relational equation of process time relative to film thickness; .
FIG. 4 is a graph showing an example of a relational equation of film thickness relative to atmospheric pressure;
FIG. 5 is a graph showing an example of a relational equation of process time relative to atmospheric pressure; and
FIG. 6 is a graph showing an example of a relational equation of corrected process time.

Best Mode for Carrying Out the Invention

Embodiments of the present invention will be described hereinafter with reference to the accompanying drawings.

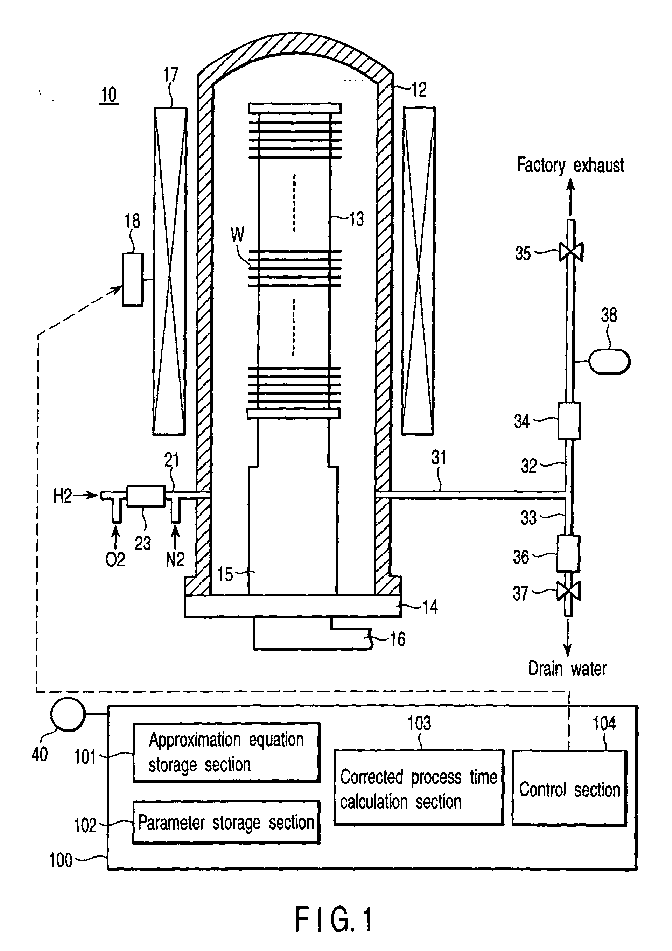

FIG. 1 is a partly sectional view showing a vertical heat-processing apparatus, which is a film formation apparatus for a semiconductor process according to an embodiment of the present invention. As shown in FIG. 1, the vertical heat-processing apparatus 10 includes a reaction tube 12 made of, e.g., quartz and having a closed top. Within the reaction tube 12, a number of, e.g., 150, substrates or semiconductor wafers W (product wafers) are held on a holder or wafer boat 13 while they are placed in a horizontal state and stacked at intervals in the vertical direction. The wafer boat 13 is supported on a lid 14 through an insulating cylinder (thermally insulating body) 15.

The lid 14 is supported by a boat elevator 16, which is used for loading and unloading the wafer boat 13 to and from the reaction tube 12. The lid 14 can close the bottom port of the process container or reaction tube 12, when it is set at the uppermost position.

A heater 17 formed of, e.g., a resistance heating body is disposed around the reaction tube 12, which is controlled by a power controller 18 for the heating value. A temperature sensor S (not shown), such as a thermo couple, is disposed on the inner wall of the reaction tube 12, to measure the temperature within the heating furnace.

A gas supply line 21 is connected to the reaction tube 12, for supplying a gas into the reaction tube 12. The gas supply line 21 is provided with a combustion chamber 23 for mixing and burning hydrogen gas and oxygen gas. Water vapor (reactive gas) is generated from the hydrogen gas and oxygen gas in the combustion chamber 23, and is then mixed with nitrogen gas (carrier gas), and supplied through the gas supply line 21 into the reaction tube 12.

Flow rate regulators (not shown), such as mass-flow controllers, are used to respectively adjust the flow rates of the hydrogen gas, oxygen gas, and nitrogen gas. For example, by stopping supply of the hydrogen gas, the oxygen gas can be used as a reactive gas, instead of water vapor. Furthermore, the mixture ratio between the reactive gas (water vapor or oxygen) and carrier gas (nitrogen gas) can be suitably changed.

An exhaust line 31 is connected to the reaction tube 12, for exhausting the gas atmosphere within the reaction tube 12. The exhaust line 31 is divided into two lines 32 and 33. One line 32 extends through a cooler 34 for cooling exhaust gas and a valve 35, and is connected to a gas exhaust system (not shown) of a factory. The other line 33 extends through a trap 36 for trapping wafer contained in exhaust gas and a valve 37, and is connected to a drain system (not shown) of the factory. Water trapped in the trap 36 is discharged into the factory drain system, when the valve 37 is opened.

A pressure sensor 38 is connected at a point along the gas exhaust line 32 to measure the pressure within the reaction tube 12. The pressure sensor 38 measures the pressure within the reaction tube 12, on the basis of atmospheric pressure used as a reference. More specifically, the pressure sensor 38 is a relative-pressure measuring device, which measures the pressure within the reaction tube 12 based on the differential pressure from atmospheric pressure.

The pressure within the reaction tube 12 may be controlled by changing the flow rates of the reactive gas and carrier gas, or changing the opening ratio of the valve 35 to adjust the volume displacement from the reaction tube 12. The balance between the gas flow rates and volume displacement determines the pressure within the reaction tube 12. Both of the gas flow rates and volume displacement may be changed to control the pressure within the reaction tube 12.

When the pressure within the reaction tube 12 is controlled, as described above, the measurement result obtained by the pressure sensor 38 is referred to. In other words, the pressure within the reaction tube 12 is controlled, on the basis of the measurement result obtained by the pressure sensor 38. A manual operation or an automatic operation by an information-processing unit 100 or the like described below may be used to control the pressure within the reaction tube 12, with reference to the measurement result obtained by the pressure sensor 38.

The heat-processing apparatus 10 includes an atmospheric pressure sensor 40 for measuring atmospheric pressure. As described later, the measurement result about atmospheric pressure by the atmospheric pressure sensor 40 is used to correct the process time. As a consequence, it is possible to prevent film thickness variation due to atmospheric pressure fluctuations.

Furthermore, the heat-processing apparatus 10 includes an information-processing unit 100 for controlling the film formation process. For example, the information-processing unit 100 can control process parameters, such as gas flow rates, pressure within the reaction tube 12, and process atmosphere temperature within the reaction tube 12. The information-processing unit 100 outputs control signals to the power controller 18 and so forth.

<Details of information-processing unit 100>

The information-processing unit 100 includes an approximation equation storage section 101, parameter storage section 102, corrected process time calculation section 103, and control section 104.

The approximation equation storage section 101 stores an approximation equation used as a corrected process time relational equation for correcting the process time in accordance with atmospheric pressure fluctuations. In this embodiment, as described later, the corrected process time relational equation is expressed as a linear approximation equation, and thus the form of the approximation equation stored in the approximation equation storage section 101 is a linear equation.

The parameter storage section 102 stores parameters corresponding to the approximation equation used as a corrected process time relational equation stored in the approximation equation storage section 101. In this case, since the approximation equation is a linear equation, the parameter storage section 102 stores a set of at least two parameters. This set may be formed of more than two parameters. The parameter storage section 102 may also store process conditions, which the corrected process time relational equation can be applied to.

As can be understood from above, the approximation equation storage section 101 and parameter storage section 102 cooperate to constitute a storage section for storing the corrected process time relational equation.

The corrected process time calculation section 103 functions as a process time correction section to calculate a process time corrected in accordance with atmospheric pressure. In this calculation, a measurement result obtained by the atmospheric pressure sensor 40 is used.

The control section 104 controls the power controller 18, on the basis of a corrected process time calculated by the corrected process time calculation section 103, and so forth. The control section 104 may adjust flow rate regulators (not shown) to control a target gas pressure P.

<Details of sequence of preventing film thickness variation due to atmospheric pressure fluctuations>

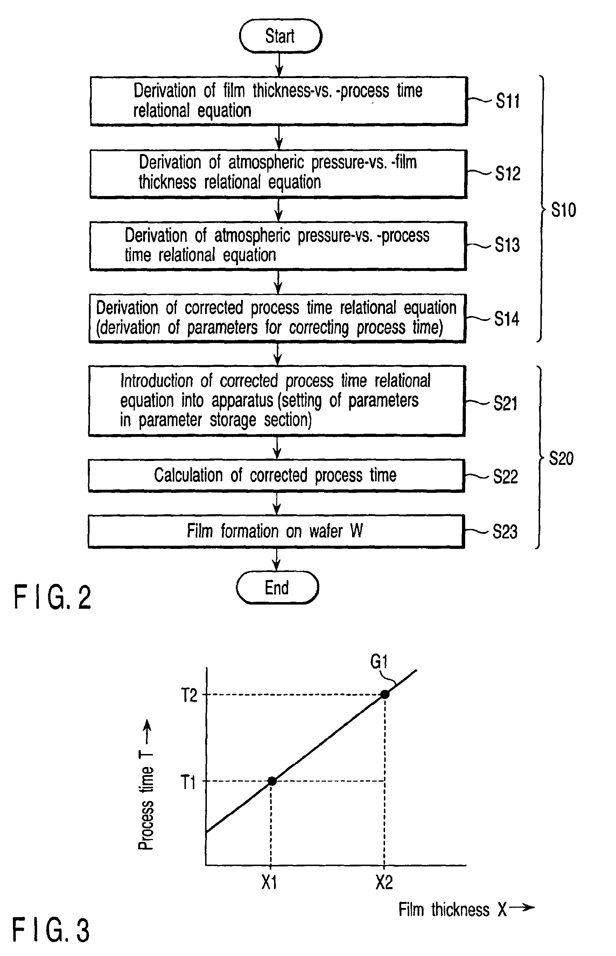

In this embodiment, the process time is corrected in accordance with atmospheric pressure, so as to prevent film thickness variation due to atmospheric pressure fluctuations. FIG. 2 is a flow chart showing a sequence of preventing film thickness variation due to atmospheric pressure. As shown in FIG. 2, the sequence of preventing film thickness variation can be divided into stages S10 and S20. The stage S10 is a period to derive a relational equation (corrected process time relational equation) that expresses the relationship between atmospheric pressure and corrected process time. The stage S20 is a period to perform film formation on wafers W, using the corrected process time relational equation thus derived.

A. Stage S10: Derivation of corrected process time relational equation

As shown in FIG. 2, the stage S10 is further divided into steps S11 to S14. Detailed explanations will be given of steps S11 to S14, one by one.

Step S11:

A film thickness-vs.-process time relational equation (X-T relational equation) is derived that expresses the relationship between the film thickness X on wafers W heat-processed by the heat-processing apparatus 10 and the process time T. This derivation is performed in the order of the following sub-steps S11-1 to S11-3.

Sub-step S11-1:

Sets of wafers W are heat-processed by the heat-processing apparatus 10 for different process time values. In other words, different process time values are respectively used for sets of wafers W in the heat-process (film formation process).
In this embodiment, the film thickness-vs.-process time relational equation is formed of a linear approximation equation. Accordingly, in a theoretical sense, two different vales of the process time suffice for it. However, in order to accurately derive the film thickness-vs.-process time relational equation, it is preferable to use different three or more process time values, and use a greater number of wafers W used as samples.
When this heat-process is performed, atmospheric pressure P is kept almost constant. This is done to prevent atmospheric pressure fluctuations from affecting the film thickness-vs.-process time relational equation derived in the sub-step S11-3 described later. At this time, atmospheric pressure P is preferably closer to a reference atmospheric pressure Pr described later, but this is not necessarily essential.
It is preferable to perform this heat-process by a heat-processing apparatus, which is the heat-processing apparatus 10 itself used to perform film formation in the stage S20. However, alternatively, a heat-processing apparatus of the same type may be used for this purpose.

Sub-step S11-2:

The film thickness on the wafers W thus heat-processed is measured. This film thickness measurement may be performed by an optical system, such as an ellipsometer.

Sub-step S11-3:

The measurement result of the film thickness is used to derive a film thickness-vs.-process time relational equation. FIG. 3 is a graph G1 showing an example of this relational equation. In this case, it is assumed that two different values T1 and T2 of the process time respectively bring about two values X1 and X2 of the film thickness on the wafer W, in order to derive a film thickness-vs.-process time relational equation by linear approximation. This relational equation is specifically expressed by the following equation (1), using time T and film thickness X. As described previously, the number of different process time values and the number of wafers W are preferably set larger. In this case, an approximation equation can be more accurately derived, using a statistical method, such as a mean-square method.

$$T = A * X + B \tag{1}$$

The linear approximation is used because, where a variation range of the process time is limited to a certain extent, the measurement result can be more reliably expressed by linear approximation.

For example, the Deal-Grove equation is known for an oxide film. It employs a quadratic equation expressed as the following equation (2), using process time T and film thickness X.

$$X2 + K1 * X = K2(T + \tau) \tag{2}$$

Since the equation (2) is obtained in a theoretical sense, it cannot represent all the actual cases of the measurement result. Specifically, there is a case where a parameter K1, K2, or $\tau$ can be hardly calculated in the equation (2) on the basis of the measurement result (it is difficult to perform so-called curve fitting).

In consideration of this fact, this embodiment employs a linear approximation equation, which is easier to handle, to express a film thickness-vs.-process time relational equation. This relational equation is not expressed by film thickness relative to process time (horizontal axis: process time), but expressed by process time relative to film thickness (horizontal axis: film thickness), because this makes it easier to convert film thickness variation into the process time, as described later. However, since this is not essential, the relational equation may be derived as an equation expressed by film thickness relative to process time.

Step S12:

An atmospheric pressure-vs.-film thickness relational equation (P-X relational equation) is derived that expresses the relationship between the atmospheric pressure P and the film thickness X on wafers W heat-processed by the heat-processing apparatus 10. This derivation is performed in the order of the following sub-steps S12-1 to S12-3.

Sub-step S12-1:

Sets of wafers W are heat-processed by the heat-processing apparatus 10 for a predetermined process time under different values of atmospheric pressure P. In other words, different values of atmospheric pressure are respectively used for sets of wafers W in the heat-process. The predetermined process time is preferably closer to a reference process time Tr described later, but this is not necessarily essential.

As in the case of the film thickness-vs.-process time relational equation, the atmospheric pressure-vs.-film thickness relational equation is preferably formed of a linear approximation equation. In order to accurately derive the relational equation, it is preferable to use different three or more process time values, and use a greater number of wafers W used as samples. Furthermore, as in the step S11, it is preferable to perform this heat-process by a heat-processing apparatus, which is the heat-processing apparatus 10 itself used to perform film formation in the stage S20. However, alternatively, a heat-processing apparatus of the same type may be used for this purpose.

Sub-step S12-2:

The film thickness on the wafers W thus heat-processed is measured. This film thickness measurement may be performed by an optical system, such as an ellipsometer, as in the step S11.

Sub-step S12-3:

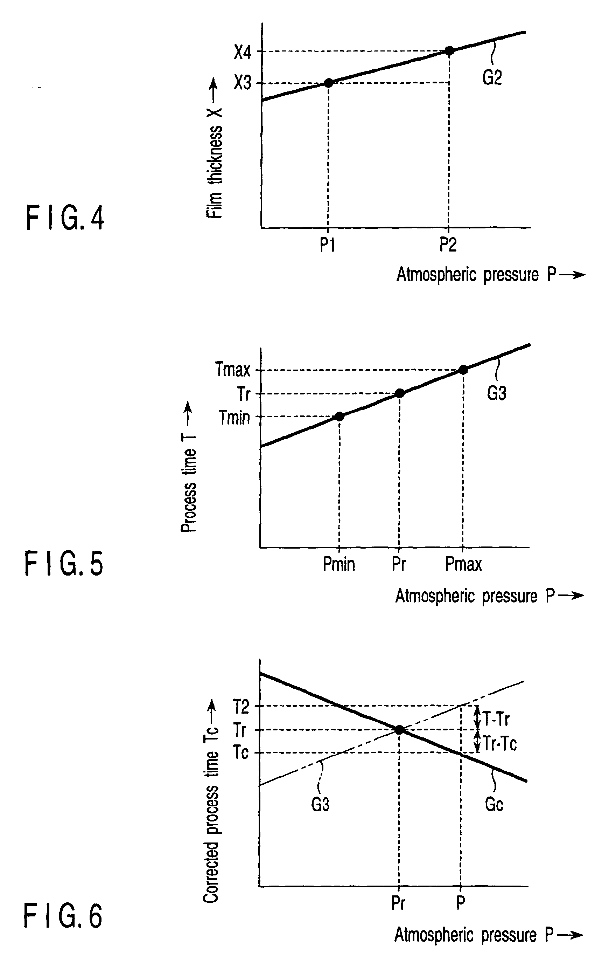

The measurement result of the film thickness is used to derive an atmospheric pressure-vs.-film thickness relational equation. FIG. 4 is a graph G2 showing an example of this relational equation. In this case, it is assumed that two different values P1 and P2 of atmospheric pressure respectively bring about two values X3 and X4 of the film thickness on the wafer W, in order to derive an atmospheric pressure-vs.-film thickness relational equation by linear approximation. This relational equation is specifically expressed by the following equation (3), using atmospheric pressure P and film thickness X. As described in the step S11, the number of different values of atmospheric pressure and the number of wafers W are preferably set larger. In this case, an approximation equation can be more accurately derived, using a statistical method, such as a mean-square method.

$$X = F * P + C \tag{3}$$

Step S13:

An atmospheric pressure-vs.-process time relational equation (P-T relational equation) is derived that expresses the relationship between the atmospheric pressure P and the process time T. This derivation is performed by substituting the equation (3) into the equation (1). Where the equation (3) is substituted into the equation (1), the following equation (4) is derived.

$$T = A * (F * P + C) + B$$
$$= A * F * P + A * C + B \qquad \text{......(4)}$$

Provided that $\alpha = A * F$ and $\beta = A * C + B$ in this equation, the following equation (5) is derived.

$$T = \alpha * P + \beta \qquad (5)$$

As can be understood from substitution of the equation (3) into the equation (1), the atmospheric pressure-vs.-process time relational equation expressed by the equation (5) means that fluctuations in the film thickness X caused by atmospheric pressure P is converted into the process time T. FIG. 5 is a graph G3 showing an example of this atmospheric pressure-vs.-process time relational equation.

This atmospheric pressure-vs.-process time relational equation (graph G5) is represented by a straight line extending through the reference atmospheric pressure Pr and the reference process time Tr. The effective range of the equation is between Pmin to and Pmax of atmospheric pressure (between Tmin and Tmax of the process time).

The effective range of the atmospheric pressure-vs.-process time relational equation is adopted in consideration of the fact that this relational equation (equation (5)) is calculated from the equations (1) and (3), which are linear approximation equations. In linear approximation equations, deviations from actually measured values become larger, as the distance increases from the reference value (the reference atmospheric pressure Pr and reference process time Tr in this case). Accordingly, the equation (5) is used only within a certain range around the reference value, so as to exclude large errors from actual values.

The reference atmospheric pressure Pr can be arbitrarily determined to a certain extent. However, the pressure is preferably set to fall within a range of atmospheric pressure P used for deriving the atmospheric pressure-vs.-process time relational equation in the step S13, and to be closer to the center value of a range of atmospheric pressure P that likely appears in practice. This allows the atmospheric pressure-vs.-process time relational equation to be more reliably effective.

The effective range of the atmospheric pressure-vs.-process time relational equation may be determined, on the basis of, e.g., a range where the atmospheric pressure-vs.-film thickness relational equation (approximation equation) shown in FIG. 4 agrees with actually measured values. Alternatively, as a convenient method, the range may be determined on the basis of the ratio relative to the reference atmospheric pressure Pr. An example of this is the following equation (6). According to experience, if the range is set to be about 10% relative to the reference atmospheric pressure Pr, it is possible to ensure the linearity of change in the film thickness (converted into the process time) relative to atmospheric pressure.

$$Pmax = Pr + 0.1 * Pr$$
$$Pmin = Pr - 0.1 * Pr \qquad (6)$$

The process time range of Tmin to Tmax is automatically determined by the atmospheric pressure range of Pmin to Pmax, in accordance with the following equation (7). In the equation (7), T(P) is expressed by the equation (5) described above.

$$Tmax = T(Pmax)$$
$$Tmin = T(Pmin) \qquad (7)$$

Step S14:

A corrected process time relational equation (Tc(P)) is derived that provides a corrected process time T relative to atmospheric pressure P. FIG. 6 shows a concept for deriving this relational equation. In FIG. 6, graphs G3 and Gc denote the atmospheric pressure-vs.-process time relational equation (derived in the step S13) and a corrected process time relational equation (Tc(P)) to be derived, respectively.

As described above, the corrected process time relational equation is arranged to correct the process time in accordance with fluctuations in atmospheric pressure P, thereby preventing film thickness variation due to atmospheric pressure fluctuations. More specifically, where atmospheric pressure increases from the reference value (reference atmospheric pressure Pr), the process time is reduced from the reference value (reference process time Tr). Where atmospheric pressure decreases from the reference value, the process time is increased from the reference value. By doing so, it is possible to compensate for fluctuations in atmospheric pressure P. The graph Gc denoting the corrected process time relational equation is a line having an inclination reverse to that of the graph G3 in plus and minus, and extending through the reference atmospheric pressure Pr and the reference process time Tr.

It is assumed that, when atmospheric pressure takes on P, the process time and the corrected process time take on T and Tc (actually a value obtained by converting the film thickness into the process time), respectively. Since the graphs G3 and Gc have inclinations reverse to each other in plus and minus, the following equation (8) is derived.

$$T - Tr = Tr - Tc \tag{8}$$

Based on the equation (8), the following equation (9) expressing the corrected process time Tc is derived as follows. In this derivation of the equation (9), the equation (4) is substituted, and a definition of $\gamma = 2Tr - \beta$ is used.

$$
\begin{aligned}
Tc(P) &= Tc \\
&= 2Tr - T \\
&= 2Tr - (\alpha * P + \beta) \\
&= -\alpha * P + (2Tr - \beta) \\
&= -\alpha * P + \gamma \qquad \ldots\ldots(9)
\end{aligned}
$$

The equation (9) may be modified into the following equation (9-1), using Pr.

$$
\begin{aligned}
Tc(P) &= 2Tr - T \\
&= 2(\alpha * Pr + \beta) - (\alpha * P + \beta) \\
&= -\alpha * P + (2\alpha * Pr + \beta) \\
&= -\alpha * P + \gamma \qquad \ldots\ldots(9-1)
\end{aligned}
$$

Since a relationship of $Tr = \alpha * Pr + \beta$ can be included in the equations (9) and (9-1), these equations can be expressed by the same form in any case.

As described above, the corrected process time relational equation is formed of an approximation equation, and thus its effective range is limited to a certain extent. Accordingly, corrected process time relational equations are preferably derived respectively for film formation conditions (recipes), such as target film thickness, so that a suitable corrected process time relational equation can be chosen in accordance with a specific film formation condition.

In the steps S11 to S14 described above, it is preferable to perform the heat-process by a heat-processing apparatus 10 used to perform film formation in the stage S20 (itself or the same type).

A computer is preferably used to derive the relational equations. Along with derivation of the relational equations, graphs as those shown in FIGS. 3 to 6 may be used to show the relationships between the actually measured values (film thickness and so forth) and relational equations.

This computer may be formed of one directly associated with the heat-processing apparatus 10 (for example, the information-processing unit 100 of the heat-processing apparatus 10, or a host computer connected to the heat-processing apparatus 10 by a network). Although this computer may be formed of one not directly associated with the heat-processing apparatus 10, communication of the computer with the heat-processing apparatus 10 facilitates the subsequent step S21 (introduction of the corrected process time relational equation into the heat-processing apparatus 10).

Software used in the computer may be dedicated or multipurpose software. An example of multipurpose software usable in this embodiment is "Excel" of Microsoft Inc.

The corrected process time relational equation thus derived is expressed by the parameters $\alpha$ and $\gamma$ in the equation (9). The reference value (one or both of the reference atmospheric pressure Pr and reference process time Tr) and the effective range (the process time range: Tmin to Tmax, the atmospheric pressure range: Pmin to Pmax) are also crucial to fault-free use of the corrected process time relational equation. Specifically, the reliability of the corrected process time relational equation is higher at a point closer to the reference value, and drops when out of the effective range

The parameters $\alpha$ and $\gamma$ are derived from the parameters A, B, F, and C. Accordingly, in place of the parameters $\alpha$ and $\gamma$, the parameters A, B, F, and C may be used to express the corrected process time relational equation. As described above, for example, the corrected process time relational equation and its effective range may be expressed, using the parameters A, B, F, and C, and the reference process time Tr. It should be noted that, if the effective range is expressed by the reference process time Tr as shown in the equations (6) and (7), there is no need to additionally use parameters (such as Pmin and Pmax) associated with the effective range.

B. Stage S20: Film formation, using derived correction time relational equation

As shown in FIG. 3, the stage S20 is further divided into steps S11 to S14. Detailed explanations will be given of steps S21 to S23, one by one.

Step S21:

The correction time relational equation is introduced into the heat-processing apparatus 10. This introduction is performed by storing parameters associated with the correction time relational equation (such as the parameters A, B, F, and C, and reference process time Tr) into the parameter storage section (parameter table) 102. Specifically, the parameters are stored in the information-processing unit 100 by a storage medium (flexible disk, CD-ROM, or the like) or network.

As describe previously, the parameter storage section 102 stores a plurality of corrected process time relational equations respectively for film formation conditions (recipes), such as target film thickness, so that a suitable corrected process time relational equation can be chosen in accordance with a film formation condition. In this case, the parameter storage section 102 preferably stores certain information (parameter or the like) that allows discrimination of film formation conditions and choice of equations.

The approximation equation storage section 101 of the information-processing unit 100 stores approximation equations that are used as bases for substituting parameters. Accordingly, the parameter storage section 102 needs to store only parameters to form corrected process time relational equations.

Step S22:

A corrected process time is calculated on the basis of current atmospheric pressure, when the film formation process actually starts (preferably immediately before the step S23). Prior to this calculation, the atmospheric pressure sensor 40 measures atmospheric pressure. Then, parameters stored in the parameter storage section 102 for corrected process time relational equations (such as the parameters A, B, F, and C, reference process time Tr) are substituted into an approximation equation (linear approximation equation) stored in the approximation equation storage section 101 to derive a corrected process time relational equation. Furthermore, the value of atmospheric pressure measured by the atmospheric pressure sensor 40 is substituted into the corrected process time relational equation to calculation a corrected process time Tc. This calculation is performed by the corrected process time calculation section 103.

There is a case where the parameter storage section 102 stores sets of parameters of corrected process time relational equations, respectively for process conditions (process recipes). In this case, a target process condition is input, and parameters corresponding to the input process condition are chosen.

Step S23:

A film is formed in accordance with the corrected process time thus calculated. This process is performed by the control section 104, while controlling the flow rate regulators (not shown) and power controller 18, on the basis of the calculated corrected process time, target process temperature T, and so forth.

As described above, the process time is increased or decreased (correction of the process time) in accordance with atmospheric pressure, so as to reduce film thickness variation due to atmospheric pressure fluctuations.

The embodiment described above may be extended or modified within the technical spirit of the present invention. For example, the film formation apparatus is not limited to a vertical heat-processing furnace. The target substrate is not limited to a semiconductor wafer, but may be, e.g., a glass substrate. The present invention is not limited by the type of reactive gas (gas species), but may be generally applied to formation of an oxide film, using oxidation species, such as oxygen or water vapor. Furthermore, the present invention is not limited to formation of an oxide film, but may be generally applied to a heat-process in which heat-processing characteristics vary due to atmospheric pressure fluctuations.

### Claims

1. A film formation method comprising a preparation stage and a process stage,

    the preparation stage comprising

    a first film formation step of forming films, while using different process times,
    a first measurement step of measuring film thickness of the films formed in the first film formation step,
    a first derivation step of deriving, based on measured data obtained in the first measurement step, a first relational equation that expresses a relationship between film thickness and process time,
    a second film formation step of forming films, while controlling process gas pressure with reference to different values of atmospheric pressure,
    a second measurement step of measuring film thickness of the films formed in the second film formation step,
    a second derivation step of deriving, based on measured data obtained in the second measurement step, a second relational equation that expresses a relationship between atmospheric pressure and film thickness, and
    a third derivation step of deriving, based on the first and second relational equations derived in the first and second derivation steps, a process time correction equation prepared to correct process time in accordance with atmospheric pressure fluctuations, and

    the process stage comprising

    a correction step of correcting process time, based on a measurement result of current atmospheric pressure and the process time correction equation derived in the third derivation step, and
    a film formation step of forming a film, while controlling process gas pressure with reference to atmospheric pressure, based on process time corrected in the correction step.

2. The method according to claim 1, wherein the third derivation step comprises

    a relational equation derivation step of deriving, based on the first and second relational equations, a third relational equation that expresses a relationship between atmospheric pressure and process time, and
    a correction equation derivation step of deriving the process time correction equation, based on the third relational equation derived in the relational equation derivation step.

3. The method according to claim 1, wherein at least one of the first and second relational equations is formed of a linear approximation equation.

4. A film formation process time correction equation derivation method of deriving a process time correction equation prepared to correct process time in accordance with atmospheric pressure fluctuations, in performing film formation while controlling process gas pressure with reference to atmospheric pressure, the method comprising:

    a first derivation step of deriving, based on first measured data, a first relational equation that expresses a relationship between film thickness and process time;
    a second derivation step of deriving, based on second measured data, a second relational equation that expresses a relationship between atmospheric pressure and film thickness; and
a third derivation step of deriving, based on the first and second relational equations derived in the first and second derivation steps, a process time correction equation prepared to correct process time in accordance with atmospheric pressure fluctuations.

**5.** The method according to claim 4, wherein the third derivation step comprises:

a relational equation derivation step of deriving, based on the first and second relational equations, a third relational equation that expresses a relationship between atmospheric pressure and process time; and
a correction equation derivation step of deriving the process time correction equation, based on the third relational equation derived in the relational equation derivation step.

**6.** The method according to claim 4, wherein at least one of the first and second relational equations is formed of a linear approximation equation.

**7.** A film formation apparatus comprising:

a process chamber configured to place a substrate therein;
a gas supply system configured to supply a reactive gas into the process chamber;
an atmospheric pressure measuring device configured to measure atmospheric pressure;
a storage section configured to store a process time correction equation prepared to correct process time in accordance with atmospheric pressure fluctuations;
a process time correction section configured to correct process time, based on the process time correction equation stored in the storage section; and
a control section configured to control the gas supply system, based on a measurement result obtained by the atmospheric pressure measuring device and process time corrected by the process time correction section.

**8.** The apparatus according to claim 7, wherein the storage section stores a plurality of the process time correction equations prepared respectively for a plurality of film formation process conditions, and
the film formation apparatus further comprises a correction equation choosing section configured to choose a process time correction equation from the plurality of process time correction equations, which corresponds to a predetermined film formation process condition.

**9.** A medium storing a program to cause a computer to execute a film formation process time correction equation derivation method according to any one of claims 4 to 6.

FIG.1

Start

| Derivation of film thickness-vs.-process time relational equation | S11 |

| Derivation of atmospheric pressure-vs.-film thickness relational equation | S12 |

| Derivation of atmospheric pressure-vs.-process time relational equation | S13 |

| Derivation of corrected process time relational equation (derivation of parameters for correcting process time) | S14 |

S10

| Introduction of corrected process time relational equation into apparatus (setting of parameters in parameter storage section) | S21 |

| Calculation of corrected process time | S22 |

| Film formation on wafer W | S23 |

S20

End

## F I G. 2

F I G. 3

FIG. 4

FIG. 5

FIG. 6

## INTERNATIONAL SEARCH REPORT

| International application No. |
| --- |
| PCT/JP03/04718 |

A. CLASSIFICATION OF SUBJECT MATTER
    Int.Cl⁷ H01L21/31

According to International Patent Classification (IPC) or to both national classification and IPC

B. FIELDS SEARCHED

Minimum documentation searched (classification system followed by classification symbols)
    Int.Cl⁷ H01L21/31

Documentation searched other than minimum documentation to the extent that such documents are included in the fields searched

| Jitsuyo Shinan Koho | 1926–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 4-125947 A  (Fujitsu Ltd.), 27 April, 1992 (27.04.92), Full text (Family: none) | 1-9 |

☐ Further documents are listed in the continuation of Box C.    ☐ See patent family annex.

| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 16 July, 2003 (16.07.03) | 12 August, 2003 (12.08.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)